# EUROPEAN PATENT SPECIFICATION

(11) **EP 4 344 371 B1**
(45) Date of publication and mention of the grant of the patent: **20.08.2025**
(21) Application number: 22197071.8
(22) Date of filing: 22.09.2022
(51) Int. Cl.: H05K 9/00

(54) **ELECTROMAGNETIC FILTER ASSEMBLY FOR ATTENUATING ELECTROMAGNETIC INTERFERENCES, FEEDTRHOUGH ASSEMBLY, ENCLOSURE ASSEMBLY AND VEHICLE**
ELEKTROMAGNETISCHE FILTERANORDNUNG ZUR DÄMPFUNG ELEKTROMAGNETISCHER STÖRUNGEN, SCHLAGWUNDENANORDNUNG, GEHÄUSEANORDNUNG UND FAHRZEUG
ENSEMBLE FILTRE ÉLECTROMAGNÉTIQUE POUR ATTÉNUER DES INTERFÉRENCES ÉLECTROMAGNÉTIQUES, ENSEMBLE DE TRANSFERT, ENSEMBLE ENCEINTE ET VÉHICULE

(43) Date of publication of application: 27.03.2024
(73) Proprietor: Volvo Car Corporation, 405 31 Göteborg (SE)
(72) Inventor: LASSON, Anders, 40531 Göteborg (SE); TORSTENSSON, Per, 40531 Göteborg (SE); MADEMLIS, Georgios, 40531 Göteborg (SE); ERIKSSON, Kurt, 40531 Göteborg (SE)
(74) Representative: Maiwald GmbH

(56) References cited:
- US-A- 5 512 196
- US-A1- 2012 071 041
- US-A1- 2018 124 938

## Description

The present disclosure relates to an electromagnetic filter assembly for attenuating electromagnetic interferences.

Moreover, the present disclosure is directed to a feedthrough assembly and an enclosure assembly for at least one electric component, comprising such an electromagnetic filter assembly.

Additionally, the present disclosure is directed to a vehicle comprising such an enclosure assembly.

The use of electromagnetic filter assemblies for attenuating electromagnetic interferences is generally known. A specific field of use of such electromagnetic filter assemblies are feedthrough assemblies, i.e. components or groups of components that are configured to transfer an electric conductor from one side of a wall to an opposite side of a wall. In the present context, a feedthrough assembly is to be understood as a feedthrough assembly for an electric conductor such as an electric cable or an electric bus bar. The wall may be a wall of an enclosure.

In this kind of applications, the electromagnetic filter assembly is used in order to block electromagnetic interferences that are generated on one side of the wall from reaching the other side of the wall. In a case in which the enclosure assembly houses an electric device, the electromagnetic filter assembly being used in conjunction with a feedthrough assembly solves two problems. First, electromagnetic interferences originating from the electric device inside the enclosure assembly are blocked from reaching an environment or an outside of the enclosure assembly where other electric installations could be disturbed. Second, electromagnetic interferences being present in the environment of the enclosure assembly do not interfere with or disturb the operation of the electric device being arranged inside the enclosure assembly.

For known electromagnetic filter assemblies, it is common to always find a trade-off between production costs, compactness and filter performance. Usually, filter assemblies having a high filter performance come together with comparatively high production costs and low compactness.

US 2018/124938 A1 teaches an electromagnetic filter assembly according to the preamble of claim 1.

It is an objective of the present invention to solve or at least reduce this conflict of objectives. Thus, an electromagnetic filter assembly shall be provided which is compact and may be produced in a cost-efficient manner. At the same time, the electromagnetic filter assembly shall have a good filter performance.

The problem is at least partially solved or alleviated by the subject matter of the independent claims of the present disclosure, wherein further examples are incorporated in the dependent claims.

According to a first aspect, there is provided an electromagnetic filter assembly for attenuating electromagnetic interferences. The filter assembly comprises a base plate having a first opening being configured to be penetrated by a first conductor from which the electromagnetic interference at least partially originates. The base plate comprises an electrically non-conductive carrier layer, an electrically conductive first layer section and an electrically conductive second layer section. The first layer section comprises a shielding interface configured to connect the first layer section to a shielding in an electrically conductive manner. The second layer section comprises a first conductor interface configured to connect the second layer section to the first conductor in an electrically conductive manner. The first layer section and the second layer section are capacitively coupled via at least two discrete capacitor elements. The fact that the first opening is configured to be penetrated by a first conductor means that a first conductor may extend through the first opening such that a first end of the first conductor is located on one side of the opening and an opposite end of the first conductor is located on an opposite side of the opening. Additionally, it has to be noted that the first layer section and the second layer section are electrically isolated from one another, i.e. they are not conductively coupled within the base plate. Moreover, the first layer section and the second layer section may be arranged directly or indirectly on the carrier layer. In this context, the terms "first" and "second" are used in order to facilitate the explanation of the electromagnetic filter assembly. These terms do not imply any number of layer sections. A discrete capacitor element may be formed by any electric component that can provide a capacitance, e.g. a classic capacitor, a varistor or a zener diode. The capacitor element may be formed as a surface mounted device (SMD) or as a through-hole component. Being discrete means that the capacitor element has a clear border with respect to its environment. Moreover, it is generally formed as a single body or a group of fixedly connected bodies. Consequently, using the electromagnetic filter assembly, the first conductor, from which the electromagnetic interference at least partially originates, may be connected to a shielding via the at least two capacitor elements. Thus, electromagnetic interferences originating from the first conductor may be attenuated in an effective manner. Moreover, due to the fact that a base plate as described above and discrete capacitor elements are compact, the electromagnetic filter assembly as a whole is compact. Furthermore, base plates may be produced in a simple and cost-efficient manner. The same is true for the assembly of discrete capacitor elements thereon. Altogether, the electromagnetic filter assembly may be manufactured in a cost-efficient manner.

According to the present disclosure, the first layer section and the second layer section are arranged at least partially opposite each other such that the first layer section and the second layer section form a capacitor. In other words, each of the first layer section and the second layer section forms an electrode of a common capacitor. In this configuration, the carrier layer may form a dielectric layer of the capacitor. This capacitor is provided in addition to the discrete capacitor elements as mentioned above. Consequently, the filtering performance is further enhanced. At the same time, the size of the electromagnetic filter assembly is not at all or just slightly increased. Additionally, the electromagnetic filter assembly may still be produced in a simple and cost-efficient manner.

In the present context, a shielding to which the first layer section may be connected in an electrically conductive manner is to be understood as an electric or electromagnetic shielding. The shielding may have any electric potential, e.g. zero volts or 12 volts. In case the shielding is at a potential of zero volts, the shielding is at ground potential. In this case, the shielding and the ground may fall together such that the shielding is formed by a ground element.

In an example, the at least two capacitor elements have the same electric capacitance.

In an example, the base plate is formed as a printed circuit board. Such base plates may be produced in an especially cost-efficient manner. Moreover, the first layer section and the second layer section may be integrated into the base plate in a compact manner. The printed circuit board may be at least partially rigid and/or at least partially flexible. Of course, the printed circuit board may also be entirely rigid or entirely flexible. The printed circuit board may also be formed as a printed circuit board tape.

It is noted that the electromagnetic filter assembly according to the present disclosure may be used for filtering interferences resulting from a conductor carrying direct current (DC), alternating current (AC) and any other type of current from which an electromagnetic interference may originate.

An electromagnetic filter assembly according to the present disclosure may be called an electromagnetic interference filter or EMI filter.

In an example, the electromagnetic filter assembly according to the present disclosure is not configured to transmit power.

In an example, the at least two discrete capacitor elements are evenly distributed around a circumference of the first opening. The at least two discrete capacitor elements may be oriented in a radial direction with respect to the first opening. Thus, in a case in which two discrete capacitor elements are provided, they are spaced by approximately 180° around the circumference of the first opening. In a case in which three capacitor elements are provided, they are spaced by approximately 120° around the circumference of the first opening. In a further case, in which four capacitor elements are provided, they are spaced by approximately 90° around the circumference of the first opening. In other words, the capacitor elements are pair-wise opposite one another, wherein the pairs are arranged orthogonally to one another. The even distribution of the capacitor elements leads to a symmetric arrangement of the capacitor elements around the first opening. Such an arrangement further enhances the filter performance. The use of additional capacitor elements increases the total capacitance and thus also improves the filter performance.

In an example, the second layer section is ring-shaped and the first conductor interface extends around the first opening in a circumferentially closed manner. In this context, ring-shaped is to be understood as being shaped like a fully closed ring. The ring may have a polygonal, e.g. rectangular, circular or elliptical geometry. This offers the possibility to connect the first conductor to the first conductor interface using the full circumference of the first conductor. This has the effect, that a comparatively big electrically conducting connection area is provided. This makes the electromagnetic filter assembly suitable for being connected to a first conductor which is transmitting comparatively high currents.

In another example, the first conductor interface just extends around a portion of the first opening. Also in this configuration, a sufficiently big electrically conducting connection area may be provided.

In an example, the base plate has a second opening being configured to be penetrated by a second conductor from which the electromagnetic interference at least partially originates. The base plate comprises an electrically conductive third layer section, wherein the third layer section comprises a second conductor interface configured to connect the third layer section to the second conductor in an electrically conductive manner. The first layer section and the third layer section are capacitively coupled via at least two discrete capacitor elements. Thus, the electromagnetic filter assembly is configured to be used in connection with two conductors, i.e. the first conductor and the second conductor, from which an electromagnetic interference at least partially originates. In a case in which the electromagnetic filter assembly is used in connection with a DC circuit, the first conductor may be connected to a DC+ pole and the second conductor may be connected to a DC- pole. In this example, both the first conductor and the second conductor may be capacitively coupled to the shielding via the respective first conductor interface and second conductor interface and the discrete capacitor elements. Consequently, an electromagnetic interference originating from the first conductor and/or the second conductor may be efficiently and effectively attenuated. All effects and advantages that have been mentioned in connection with the first conductor also apply to the second conductor. It is noted that the term "third" is just used for the ease of explanation. A number of layer sections is not implied.

In another example, the base plate has a second opening being configured to receive a second conductor from which the electromagnetic interference at least partially originates. The base plate comprises an electrically conductive third layer section, wherein the third layer section comprises a second conductor interface configured to connect the third layer section to the second conductor in an electrically conductive manner. The base plate may additionally comprise an electrically conductive fourth layer section, wherein the fourth layer section comprises a shielding interface configured to connect the fourth layer section to the shielding in an electrically conductive manner. The third layer section and the fourth layer section are arranged at least partially opposite each other such that the third layer section and the fourth layer section form a capacitor. Additionally or alternatively, the third layer section and the fourth layer section are capacitively coupled via at least two discrete capacitor elements. As before, the term "fourth" is just used for the ease of explanation. A number of layer sections is not implied. In the present example, at least two discrete capacitor elements are coupling the first conductor interface, to which the first conductor may be connected, and the shielding interface. To this end, the first layer section is provided. Additionally, at least two discrete capacitor elements are coupling the second conductor interface, to which the second conductor may be connected, and the shielding interface. To this end, the fourth layer section is provided. Thus, in total, at least four discrete conductor elements are provided. In this context, the first layer section and the fourth layer section may be arranged on opposite ends of the base plate. Consequently, also in this configuration, an electromagnetic interference originating from the first conductor and/or from the second conductor may be efficiently and effectively attenuated.

In examples in which the base plate comprises a second layer section and a third layer section being configured to be connected to a first conductor and a second conductor respectively, the second layer section and the third layer section can be placed in parallel with only an isolating (dielectric) layer in between. Consequently, a differential capacitance is formed between these layer sections. Such a capacitance attenuates differential mode disturbances between the second layer section and the third layer section and the corresponding conductors.

In an example, the at least two discrete capacitor elements are evenly distributed around a circumference of the second opening. Also in this configuration, the same effects and advantages apply that have already been explained in connection with the at least two discrete capacitor elements that are evenly distributed around the circumference of the first opening. Reference is made to the above explanations.

In an example, the third layer section is ring-shaped and the second conductor interface extends around the opening in a circumferentially closed manner. Again, ring-shaped is to be understood as being shaped like a fully closed ring. This offers the possibility to connect the second conductor to the second conductor interface using the full circumference of the second conductor. This has the effect, that a comparatively big electrically conducting connection area is provided. This makes the electromagnetic filter assembly suitable for being connected to a second conductor which is transmitting comparatively high currents.

In an example, the shielding interface comprises a plurality of shielding interface sections being spaced from one another. In this context, the plurality of shielding interface sections may be distributed along an edge of the base plate. In any case, a plurality of shielding interface sections is provided such that the electric connection to the shielding is established at different locations. Additionally, a conductive area of the shielding interface is formed by the sum of the conductive areas of the plurality of shielding interface sections. Consequently, a comparatively big conductive area may be provided such that the connection to the shielding may have a comparatively low resistance and low impedance. As a result thereof, the electromagnetic filter assembly has a good filter performance.

In an example, each shielding interface section at least partially extends around a respective shielding connection hole being configured to receive a shielding connection bolt. In other words, the shielding interface is configured to be connected to a shielding via shielding connection bolt. These shielding connection bolts are to be placed in respective shielding connection holes. Thereby, a highly reliable shielding connection may be established in the electric sense. Additionally, the shielding connection bolt may reliably connect the electromagnetic filter assembly to a shielding in a mechanical sense.

In an example, the shielding interface comprises at least one shielding interface section extending along an edge of the first layer section. Such a shielding interface section may be described as line-shaped. The line may have corners and/or curves. The shielding interface section may also fully cover all exterior edges of the first layer section. Consequently, a comparatively big conductive area may be provided such that the connection to the shielding may have a comparatively low resistance and low impedance. As a result thereof, the electromagnetic filter assembly has a good filter performance.

It is noted that even though in the above examples, an electromagnetic filter assembly for one or two conductors has been explained in detail, it is also possible to configure the electromagnetic filter assembly such that it is adapted for being used in combination with three or more conductors, especially in combination with three, four or five conductors.

It is additionally noted that even though in the above examples, two to four electrically conductive layer sections have been described as forming part of the base plate, the base plate can also comprise more than four electrically conductive layer sections.

According to a second aspect, there is provided a feedthrough assembly. The feedthrough assembly comprises an electromagnetic filter assembly according to the present disclosure and a first conductor. The first conductor extends through the first opening and is connected to the second layer section in an electrically conductive manner via the first conductor interface. The first conductor may be electrically connected to the first conductor interface using its entire circumference. Consequently, an electromagnetic interference originating at least partly from the first conductor may be attenuated in a reliable and effective manner.

In an example, the feedthrough assembly also comprises a second conductor which is connected to the second conductor interface in an electrically can ducted manner. The second conductor may be electrically connected to the second conductor interface using its entire circumference. Consequently, an electromagnetic interference originating at least partly from the second conductor may be attenuated in a reliable and effective manner.

According to a third aspect, there is provided an enclosure assembly for at least one electric component. The enclosure assembly comprises an electromagnetic filter assembly according to the present disclosure and an enclosure having at least one wall. The wall has a wall opening being at least partially covered by the base plate of the electromagnetic filter assembly. The first layer section of the electromagnetic filter assembly is connected to the wall in an electrically conductive manner via the shielding interface. It is understood that at least the portion of the wall to which the first layer section is connected, is electrically conductive. In another example, the entire wall is electrically conductive. In a further example, the entire enclosure is electrically conductive. Thus, electromagnetic interferences originating at least partly from a conductor which extends through the wall opening and the first opening of the electromagnetic filter assembly may be attenuated in an effective and reliable manner. Consequently, the electric component being arranged in the enclosure assembly may be efficiently and effectively protected from electromagnetic interferences resulting from an outside of the enclosure assembly. At the same time, an environment or outside of the enclosure assembly may be protected from electromagnetic interferences resulting from the electric component inside the enclosure assembly.

In an example, the enclosure assembly is an electromagnetic shielding assembly that is configured to electromagnetically separate an interior of the enclosure assembly from an exterior of the enclosure assembly. Optionally, the enclosure assembly may also separate the interior and the exterior in a mechanical and thermal sense. In other words, the enclosure assembly may also be configured to mechanically protect the interior of the enclosure assembly from mechanical influences resulting from the exterior of the enclosure assembly and vice versa. Moreover, the enclosure assembly may be configured to thermally protect the interior of the enclosure assembly from thermal influences resulting from the exterior of the enclosure assembly and vice versa.

In a case in which the enclosure assembly is an electromagnetic shielding assembly, the enclosure may be called a shielding enclosure.

In an example, the enclosure assembly is configured to enclose an inverter unit, i.e. a DC-AC converter unit. Additionally or alternatively, the enclosure assembly may be configured to enclose an AC-DC converter, a DC-DC converter unit and/or an AC-AC converter unit.

In an example, the enclosure assembly further comprises a first conductor, wherein the first conductor extends through the first opening and is connected to the second layer section in an electrically conductive manner via the first conductor interface. In other words, the enclosure assembly comprises the feedthrough assembly according to the present disclosure. In this context, all the effects and advantages that have already been mentioned in connection with the feedthrough assembly and/or the electromagnetic filter assembly apply mutatis mutandis.

According to a fourth aspect, there is provided a vehicle comprising an enclosure assembly according to the present disclosure. The enclosure assembly forms part of a drivetrain of the vehicle. As has already been mentioned, inside the enclosure assembly, an inverter unit, i.e. a DC-AC converter unit, an AC-DC converter unit, a DC-DC converter unit or an AC-AC converter unit may be located. Consequently, the drivetrain of the vehicle or more specifically the mentioned components of the drivetrain, are reliably protected from electromagnetic interferences resulting from an environment of the drivetrain. At the same time, the environment of the drivetrain is reliably protected from electromagnetic interferences resulting from the drivetrain.

It is noted that in a case in which the filter assembly according to the present disclosure, the feedthrough assembly and/or the enclosure assembly are used in a vehicle, the first conductor and/or the second conductor may be subject to comparatively high currents, voltages and/or power. For example, the first conductor and/or the second conductor may be subject to 60 V direct current or more. In another example, the first conductor and/or the second conductor may be subject to at least 25 V (root mean square value) alternating current.

In these kinds of applications, the first conductor and/or the second conductor may be used for power supply.

These and other aspects of the present disclosure will become apparent from and elucidated with reference to the examples described hereinafter.

Examples of the disclosure will be described in the following with reference to the drawings.
- Figure 1: shows a vehicle according to the present disclosure having a drivetrain with an enclosure assembly according to the present disclosure, wherein the enclosure assembly comprises a feedthrough assembly according to the present disclosure with an electromagnetic filter assembly according to the present disclosure,
- Figure 2: shows a detail of the enclosure assembly of Figure 1 in a sectional view,
- Figure 3: shows a detail of the enclosure assembly of Figure 1 in a perspective view from an inside of the enclosure assembly,
- Figure 4: shows the detail of Figure 3 along a direction IV in Figure 3,
- Figure 5: shows an example of an enclosure assembly having a feedthrough assembly according to another example with an electromagnetic filter assembly not according to the invention and being presented for illustration purposes only in a sectional view,
- Figure 6: shows the enclosure assembly of Figure 5 along direction VI in Figure 5,
- Figure 7: shows a further example of an enclosure assembly according to the present disclosure having a feedthrough assembly according to a further example of the present disclosure with an electromagnetic filter assembly according to a further example of the present disclosure in a sectional view,
- Figure 8: shows the enclosure assembly of Figure 7 along direction VIII in Figure 7,
- Figure 9: shows the feedthrough assembly of Figure 7 along direction IX in Figure 7,
- Figure 10: shows a further example of an enclosure assembly according to the present disclosure having a feedthrough assembly according to a further example of the present disclosure with an electromagnetic filter assembly according to a further example of the present disclosure in a sectional, schematic view,
- Figure 11: shows the enclosure assembly of Figure 10 in a perspective view, and
- Figure 12: shows the enclosure assembly of Figure 11 in a top view.

The Figures are merely schematic representations and serve only to illustrate examples of the disclosure. Identical or equivalent elements are in principle provided with the same reference signs.

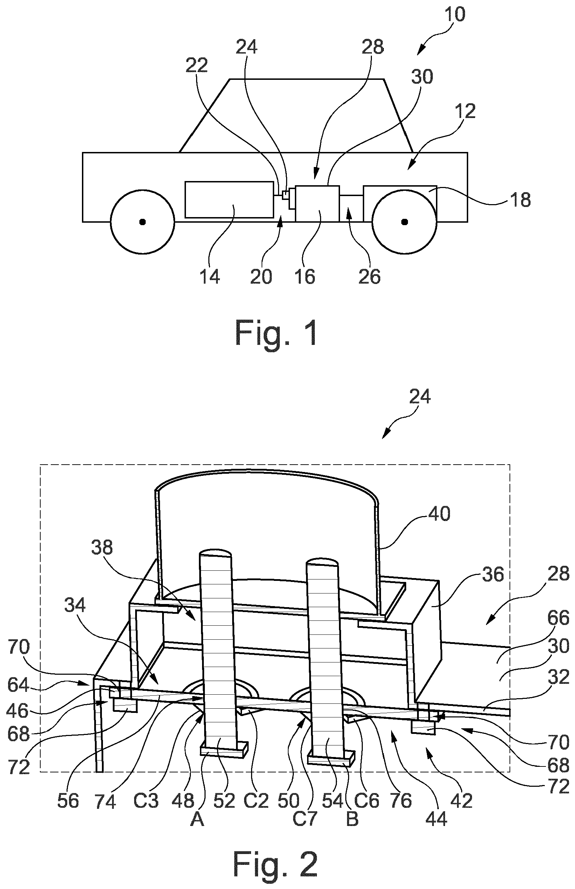

Figure 1 shows a vehicle 10 which in the present example is a battery electric vehicle.

The vehicle 10 has a drivetrain 12 which comprises a battery unit 14, an inverter unit 16 and an electric motor unit 18.

The battery unit 12 and the inverter unit 16 are electrically connected by a first electric connection 20. In the present example, the first electric connection 20 comprises a cable 22 which is mechanically and electrically connected to a connector 24 of the inverter unit 16.

The inverter unit 16 and the electric motor unit 18 are electrically connected by a second electric connection 26.

The inverter unit 16 comprises an enclosure assembly 28. Consequently, the enclosure assembly 28 also forms part of the drivetrain 12.

The enclosure assembly 28 comprises an enclosure 30.

In the present example, the enclosure 30 is configured to house the components of the inverter unit 16 which are configured to transform a 2-phase DC current being provided by the battery unit 14 into a three-phase AC current for operating the electric motor unit 18. More precisely, the enclosure 30 is configured to separate these components from an environment of the inverter unit 16 in a mechanical, thermal and electromagnetic sense. The separation in an electromagnetic sense may also be called an electromagnetic shielding which is performed by the enclosure 30.

It is noted that the components for transforming the 2-phase DC current into a 3-phase AC current are not shown in the Figures for the ease of representation.

Details of the enclosure assembly 28 can be seen in Figures 2 to 4.

The enclosure 30 comprises several walls 32 which delimit the enclosure 30.

The wall 32 which is oriented towards the battery unit 14 comprises a wall opening 34.

On an outside of the enclosure 30, a projection element 36 is mounted to the wall 32 such that it covers the wall opening 34. On an end of the projection element 36 which is arranged opposite the wall opening 34, a projection element opening 38 is provided. This projection element opening 38 is covered by a housing 40 of the connector 24.

On an inside of the enclosure 30, a feedthrough assembly 42 is mounted to the wall 32.

The feedthrough assembly 42 comprises an electromagnetic filter assembly 44 for attenuating electromagnetic interferences. The electromagnetic filter assembly 44 has a base plate 46 with a first opening 48 and a second opening 50.

The base plate 46 fully covers the wall opening 34.

Moreover, the feedthrough assembly 42 comprises a first conductor 52 and a second conductor 54.

Both the first conductor 52 and the second conductor 54 are formed by conduction rods which extend from an interior of the enclosure 30 through the respective first opening 48 or second opening 50, through the interior of the projection element 36 and through the projection element opening 38 such that an end of the first conductor 52 and an end of the second conductor 54 protrude into the housing 40 of the connector 24.

As has been explained before, the battery unit 14 can be connected to the inverter unit 16 via the connector 24. Consequently, the first conductor 52 may also be called a DC+ connector and the second conductor 54 may be called a DC- connector or vice versa.

Inside the enclosure, two bus bars A, B are connected to the first conductor 52 and the second conductor 54 respectively

The first conductor 52 and the second conductor 54 extend in parallel.

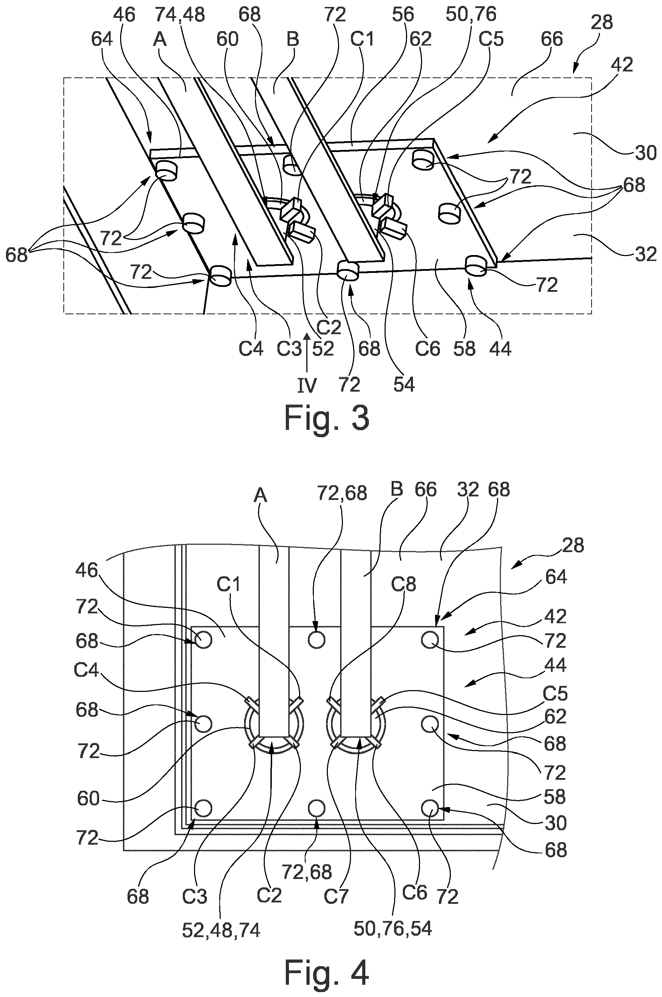

The electromagnetic filter assembly 44 may be seen best in Figures 3 and 4.

As has already been mentioned, the electromagnetic filter assembly 44 comprises the base plate 46 having the first opening 48 which is configured to be penetrated by the first conductor 52 and the second opening 50 being configured to be penetrated by the second conductor 54.

In the present example, it is assumed, that the electromagnetic interference at least partially originates from the first conductor 52 and the second conductor 54.

The base plate 46 comprises a non-conductive carrier layer 56. In the present example, the non-conductive carrier layer 56 substantially covers the full area of the base plate 46 except for the first opening 48 and the second opening 50.

Moreover, the base plate 46 comprises an electrically conductive first layer section 58, an electrically conductive second layer section 60 and an electrically conductive third layer section 62. The first layer section 58, the second layer section 60 and the third layer section 62 are electrically isolated from one another.

Beyond that, the first layer section 58, the second layer section 60 and the third layer section 62 are arranged in a common plane.

The first layer section 58 comprises a shielding interface 64 which is configured to connect the first layer section 58 to a shielding 66 in an electrically conductive manner. In the present example, the enclosure 30 forms the shielding 66.

The shielding interface 64 comprises a plurality of shielding interface sections 68 being spaced from one another. A total of eight shielding interface section 68 is provided. Each shielding interface section 68 extends around a respective shielding connection hole 70 being configured to receive a shielding connection bolt 72.

In the present example, thus, the first layer section 58 is connected to the shielding 66 in an electrically conductive manner via a total of eight connection bolts 72.

It is noted that as an alternative to connecting the first layer section 58 and the shielding 66 via shielding connection bolts 72, the shielding interface 64 may also comprise at least one shielding interface section 68 extending along an edge of the first layer section 58, i.e. an elongated shielding interface section 68 such as a soldered joint.

The second layer section 60 comprises a first conductor interface 74 which is configured to connect the second layer section 60 to the first conductor 52 in an electrically conductive manner.

The second layer section 60 is ring-shaped and the first conductor interface 74 extends around the first opening 48 in a circumferentially closed manner.

Moreover, in the present example, the first conductor 52 is connected to the first conductor interface 74 by a press fit such that the first conductor 52 is connected to the first conductor interface 74 substantially over its entire circumference. As an alternative to the press fit, a solder joint may be provided.

In the present example, in order to provide the filtering effect, the second layer section 60 is capacitively coupled to the first layer section 58 via a total of four discrete capacitor elements C1, C2, C3, C4. The capacitor elements C1, C2, C3, C4 are evenly distributed around a circumference of the first opening 48 and, thus, also around a circumference of the first conductor 52.

The third layer section 62 comprises a second conductor interface 76 which is configured to connect the third layer section 62 to the second conductor 54 in an electrically conductive manner.

The third layer section 62 is ring-shaped and the second conductor interface 76 extends around the second opening 50 in a circumferentially closed manner.

Moreover, in the present example, the second conductor 54 is connected to the second conductor interface 76 by a press fit such that the second conductor 54 is connected to the second conductor interface 76 substantially over its entire circumference. As an alternative to the press fit, a solder joint may be provided.

In the present example, in order to provide the filtering effect, the third layer section 62 is capacitively coupled to the first layer section 58 via a total of four discrete capacitor elements C5, C6, C7, C8. The capacitor elements C5, C6, C7, C8 are evenly distributed around a circumference of the second opening 50 and, thus, also around a circumference of the second conductor 54 (see especially Figure 4).

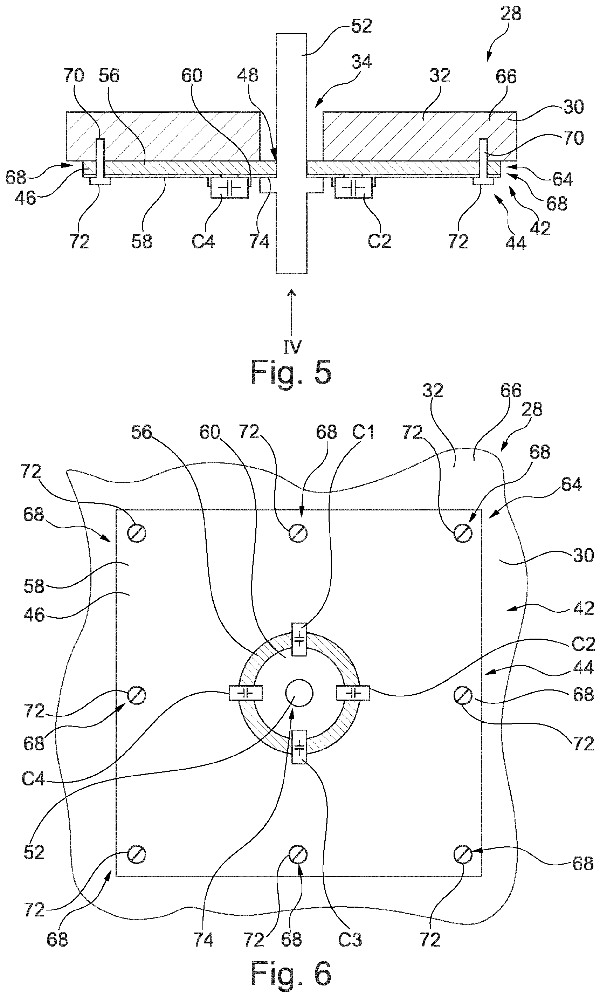

Figures 5 and 6 show another example of the enclosure assembly 28.

In the following, only the difference is with respect to the example as explained in connection with Figures 2 to 4 will be explained. Same or corresponding elements will be provided with the same reference signs.

In the example of Figures 5 and 6, the enclosure 30 is not provided with a projection element. Neither is the enclosure 30 equipped with a connector.

A further difference relates to the fact, that in the example of Figures 5 and 6 only one conductor is provided. For ease of explanation, this conductor will be referred to as the first conductor 52 in the following. However, it is obvious that the conductor could also be designated as a second conductor 54.

Beyond that, especially as far as the electrically conductive first layer section 58 and the electrically conductive second layer section 60 and the discrete capacitor elements C1, C2, C3, C4 are concerned, reference is made to the above explanations.

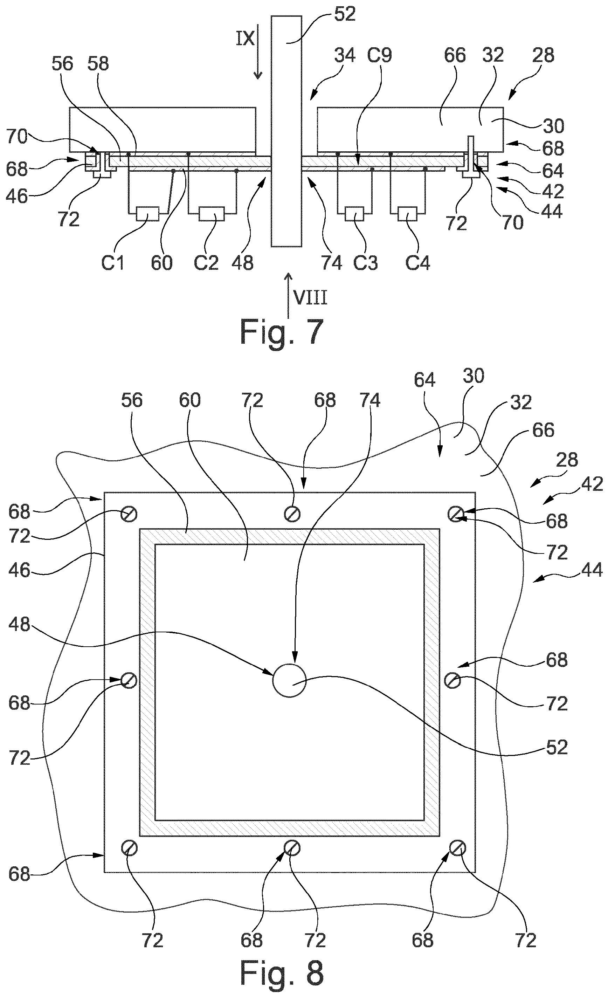

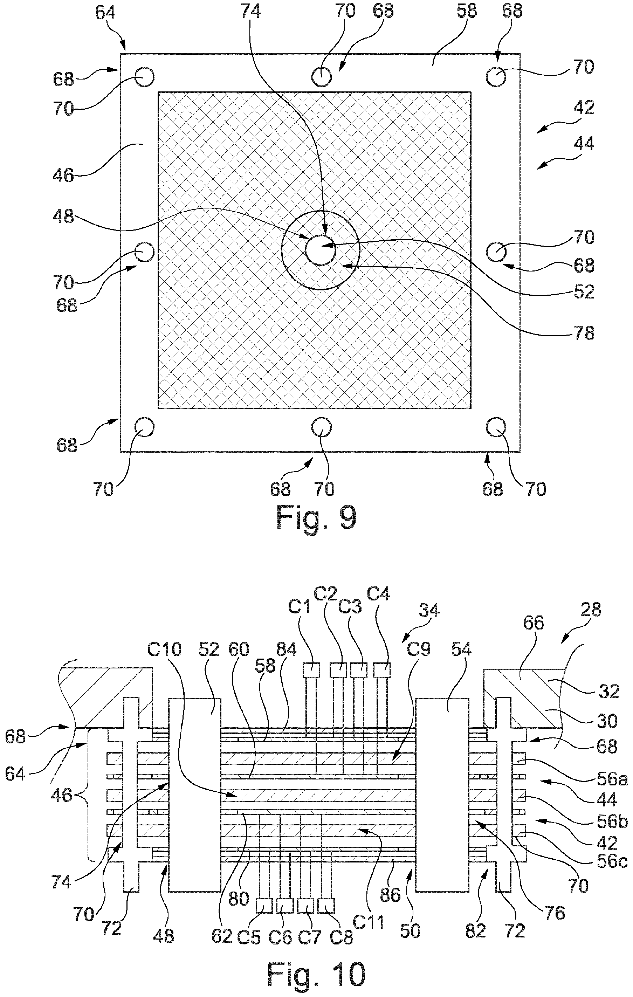

Figures 7 to 9 show a further example of the enclosure assembly 28, wherein Figure 9 only shows the feedthrough assembly 42 without the enclosure 30.

In the following, only the difference is with respect to the previous examples will be explained. Same or corresponding elements will be designated with the same reference signs.

The enclosure 30 in the example of figures 7 to 9 is the same as in the example of Figures 5 and 6.

Moreover, also in the example of Figures 7 to 9, only one conductor is provided. This conductor will be designated as a first conductor 52. However, it is obvious that the conductor could also be designated as a second conductor 54.

In contrast to the previous examples, now the first layer section 58 comprising the shielding interface 64 and the second layer section 60 comprising the first conductor interface 74 are arranged opposite each other. More precisely, the first layer section 58 and the second layer section 60 are arranged on opposite sides of the carrier layer 56.

Consequently, the first layer section 58 and the second layer section 60 form a capacitor C9.

The capacitor C9 comes in addition to the capacitor elements C1, C2, C3, C4.

For reasons of better visibility of the capacitor C9, capacitor elements C1, C2, C3, C4 have been represented in a schematic manner only in Figure 7. In Figures 8 and 9, the capacitor elements C1, C2, C3, C4 are not represented at all.

Since the first layer section 58 and the second layer section 60 form electrodes of the capacitor C9, it is important that the first layer section 58 only is conductively coupled with the enclosure 30 or the shielding 66 via the shielding interface 64.

In other words, a middle part of the first layer section 58 must be isolated with respect to the enclosure 30. To this end, an isolation layer 78 is provided on the first layer section 58 such that it is interposed between the first layer section 58 and the enclosure 30 when the electromagnetic filter assembly 44 is mounted to the enclosure 30.

Figures 10 to 12 show a further example of the enclosure assembly 28.

As before, only the differences with respect to the previous examples will be explained. Same or corresponding elements will be provided with the same reference signs.

Figure 10 comprises a schematic, sectional representation of the enclosure assembly 28.

As in the example of Figures 2 to 4, two conductors, i.e. a first conductor 52 and a second conductor 54, are provided.

However, in contrast to the preceding examples, now a total of three non-conductive carrier layers 56 is provided. In Figure 10, these carrier layers 56 are designated as carrier layers 56a, 56b, 56c.

The electrically conductive first layer section 58 is arranged on top of carrier layer 56a. As before, the first layer section 58 is connected to the enclosure 30 or shielding 66 by a plurality of shielding connection bolts 72.

Also as in the previous examples, the first conductor 52 is connected to the electrically conductive second layer section 60 in an electrically conductive manner.

The electrically conductive second layer section 60 is arranged below the carrier layer 56a.

Consequently, the first layer section 58 and the second layer section 60 form the capacitor C9 as has already been explained in connection with the example of Figure 7. The carrier layer 56a forms a dielectric of the capacitor C9.

Below the second layer section 60, carrier layer 56b is arranged.

Below carrier layer 56b, there is provided the third layer section 62. As before, the third layer section 62 is connected to the second conductor 54 in an electrically conductive manner.

Consequently, in the present example, also the second layer section 60 and the third layer section 62 form a capacitor C10. Carrier layer 56b is a dielectric of this capacitor C10.

Below the third layer section 62, there is arranged carrier layer 56c.

Below carrier layer 56c, a fourth electrically conductive layer section 80 is arranged.

The fourth electrically conductive layer section 80 comprises a shielding interface 82 configured to connect the fourth layer section 80 to the shielding 66 in an electrically conductive manner. In the present example, the fourth electrically conductive layer 80 is connected to the enclosure 30 or shielding 66 by a plurality of shielding connection bolts 72.

The third layer section 62 and the fourth layer section 80 are arranged opposite each other and, thus, the third layer section 62 and the fourth layer section 80 from a capacitor C11.

In the representation of Figure 10, the base plate 46 additionally comprises a top protection layer 84 and a bottom protection layer 86. These layers do not have a filtering functionality

Beyond that, the first layer section 58 and the second layer section 60 are capacitively coupled by a total of four discrete capacitor elements C1, C2, C3, C4 which are illustrated in a schematic manner in Figure 10.

Moreover, also the third layer section 62 and the fourth layer section 80 are capacitively coupled by a total of four discrete capacitor elements C5, C6, C7, C8 which are illustrated in a schematic manner in Figure 10.

Optionally, the second layer section 60 and the third layer section 62 may be capacitively coupled by one or more discrete capacitor elements. Using such discrete capacitor elements, differential disturbances between the first conductor 52 and the second conductor 54 may be attenuated. These discrete capacitor elements are not shown in the Figures for the ease of representation.

Consequently, the example of Figures 10 to 12 can be seen as a combination of the example of Figures 2 to 4 and the example of Figures 7 to 9. Reference is specifically made to the above explanations.

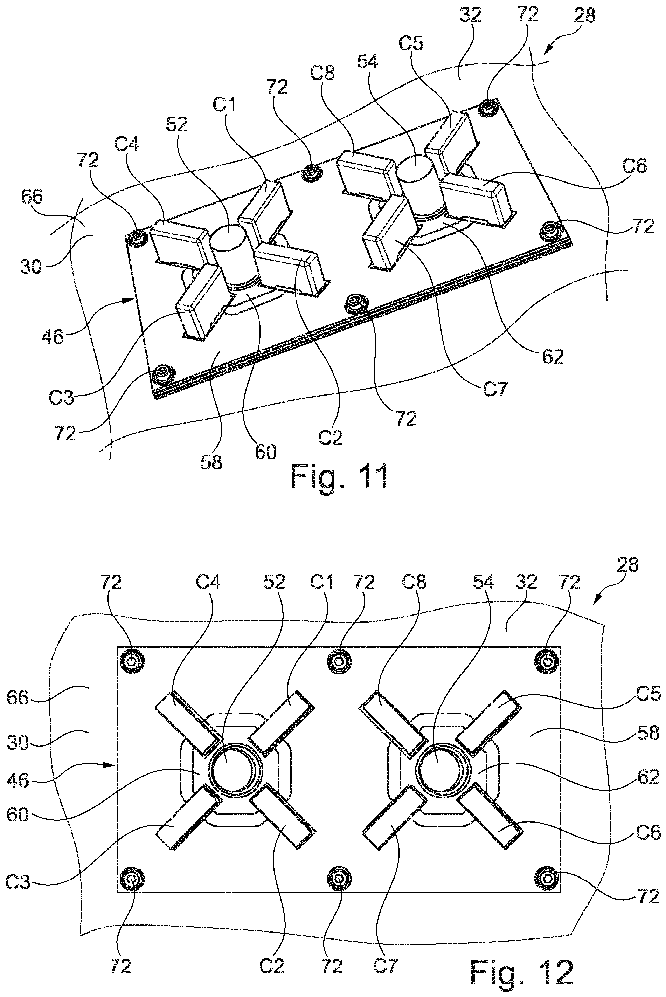

Figures 11 and 12 show a non-sectional representation of the enclosure assembly 28. As can be seen from the Figures, capacitor elements C1, C2, C3, C4 are evenly distributed around the circumference of the first opening 48 and capacitor elements C5, C6, C7, C8 are evenly distributed around the circumference of the second opening 50.

### LIST OF REFERENCE SIGNS

- 10: vehicle
- 12: drivetrain
- 14: battery unit
- 16: inverter unit
- 18: electric motor unit
- 20: first electric connection
- 22: cable
- 24: connector
- 26: second electric connection
- 28: enclosure assembly
- 30: enclosure
- 32: wall
- 34: wall opening
- 36: projection element
- 38: projection element opening
- 40: housing
- 42: feedthrough assembly
- 44: electromagnetic filter assembly
- 46: base plate
- 48: first opening
- 50: second opening
- 52: first conductor
- 54: second conductor
- 56: non-conductive carrier layer
- 58: electrically conductive first layer section
- 60: electrically conductive second layer section
- 62: electrically conductive third layer section
- 64: shielding interface
- 66: shielding
- 68: shielding interface section
- 70: shielding connection hole
- 72: shielding connection bolt
- 74: first conductor interface
- 76: second conductor interface
- 78: isolation layer
- 80: electrically conductive fourth layer section
- 82: shielding interface
- 84: top protection layer
- 86: bottom protection layer

- A: bus bar
- B: bus bar
- C1 to C8: discrete capacitor element
- C9: capacitor
- C10: capacitor
- C11: capacitor

## Claims

1. An electromagnetic filter assembly (44) for attenuating electromagnetic interferences, comprising a base plate (46) having a first opening (48) being configured to be penetrated by a first conductor (52) from which the electromagnetic interference at least partially originates,
wherein the base plate (46) comprises an electrically non-conductive carrier layer (56), an electrically conductive first layer section (58) and an electrically conductive second layer section (60),
wherein the first layer section (58) comprises a shielding interface (64) configured to connect the first layer section (58) to a shielding (66) in an electrically conductive manner,
wherein the second layer section (60) comprises a first conductor interface (74) configured to connect the second layer section (60) to the first conductor (52) in an electrically conductive manner, and
wherein the first layer section (58) and the second layer section (60) are capacitively coupled via at least two discrete capacitor elements (C1, C2, C3, C4),
**characterized in that** the first layer section (58) and the second layer section (60) are arranged at least partially opposite each other such that the first layer section (58) and the second layer section (60) form a capacitor (C9).

2. The electromagnetic filter assembly (44) of claim 1, wherein the at least two discrete capacitor elements (C1, C2, C3, C4) are evenly distributed around a circumference of the first opening (48).

3. The electromagnetic filter assembly (44) of any one of the preceding claims, wherein the second layer section (60) is ring-shaped and wherein the first conductor interface (74) extends around the first opening (48) in a circumferentially closed manner.

4. The electromagnetic filter assembly (44) of any one of the preceding claims, wherein the base plate (46) has a second opening (50) being configured to be penetrated by a second conductor (54) from which the electromagnetic interference at least partially originates,
wherein the base plate (46) comprises an electrically conductive third layer section (62), wherein the third layer section (62) comprises a second conductor interface (76) configured to connect the third layer section (62) to the second conductor (54) in an electrically conductive manner,
wherein the first layer section (58) and the third layer section (62) are capacitively coupled via at least two discrete capacitor elements (C5, C6, C7, C8).

5. The electromagnetic filter assembly (44) of any one of claims 1 to 3, wherein the base plate (46) has a second opening (50) being configured to receive a second conductor (54) from which the electromagnetic interference at least partially originates,
wherein the base plate (46) comprises an electrically conductive third layer section (62), wherein the third layer section (62) comprises a second conductor interface (76) configured to connect the third layer section (62) to the second conductor (54) in an electrically conductive manner,
wherein the base plate (46) comprises an electrically conductive fourth layer section (80),
wherein the fourth layer section (80) comprises a shielding interface (82) configured to connect the fourth layer section (80) to the shielding (66) in an electrically conductive manner,
wherein the third layer section (62) and the fourth layer section (80) are arranged at least partially opposite each other such that the third layer section (62) and the fourth layer section (80) form a capacitor (C11) and/or wherein the third layer section (62) and the fourth layer section (80) are capacitively coupled via at least two discrete capacitor elements (C5, C6, C7, C8).

6. The electromagnetic filter assembly (44) of claim 4 or 5, wherein the at least two discrete capacitor elements (C5, C6, C7, C8) are evenly distributed around a circumference of the second opening (50).

7. The electromagnetic filter assembly (44) of any one of the preceding claims, wherein the shielding interface (64, 82) comprises a plurality of shielding interface sections (68) being spaced from one another.

8. The electromagnetic filter assembly (44) of claim 7, wherein each shielding interface section (68) at least partially extends around a respective shielding connection hole (70) being configured to receive a shielding connection bolt (72).

9. The electromagnetic filter assembly (44) of any one of the preceding claims, wherein the shielding interface (64) comprises at least one shielding interface section (68) extending along an edge of the first layer section (58).

10. A feedthrough assembly (42), comprising an electromagnetic filter assembly (44) according to any one of the preceding claims and a first conductor (52), wherein the first conductor (52) extends through the first opening (48) and is connected to the second layer section (60) in an electrically conductive manner via the first conductor interface (74).

11. An enclosure assembly (28) for at least one electric component, comprising an electromagnetic filter assembly (44) according to any one of claims 1 to 9 and an enclosure (30) having at least one wall (32),
wherein the wall (32) has a wall opening (34) being at least partially covered by the base plate (46) of the electromagnetic filter assembly (44), and
wherein the first layer section (58) is connected to the wall (32) in an electrically conductive manner via the shielding interface (64).

12. The enclosure assembly (28) of claim 11, further comprising a first conductor (52), wherein the first conductor (52) extends through the first opening (48) and is connected to the second layer section (60) in an electrically conductive manner via the first conductor interface (74).

13. A vehicle (10) comprising an enclosure assembly (28) according to claim 11 or 12, wherein the enclosure assembly (28) forms part of a drivetrain (12) of the vehicle (10).

## Patentansprüche

1. Elektromagnetische Filteranordnung (44) zum Abschwächen elektromagnetischer Störungen, umfassend eine Basisplatte (46) mit einer ersten Öffnung (48), die eingerichtet ist, um von einem ersten Leiter (52) durchdrungen zu sein, von dem die elektromagnetische Störung zumindest teilweise ausgeht,
wobei die Basisplatte (46) eine elektrisch nichtleitende Trägerschicht (56), einen elektrisch leitenden ersten Schichtabschnitt (58) und einen elektrisch leitenden zweiten Schichtabschnitt (60) umfasst,
wobei der erste Schichtabschnitt (58) eine Abschirmungsschnittstelle (64) umfasst, die eingerichtet ist, um den ersten Schichtabschnitt (58) mit einer Abschirmung (66) auf elektrisch leitende Weise zu verbinden,
wobei der zweite Schichtabschnitt (60) eine erste Leiterschnittstelle (74) umfasst, die eingerichtet ist, um den zweiten Schichtabschnitt (60) mit dem ersten Leiter (52) auf elektrisch leitende Weise zu verbinden, und
wobei der erste Schichtabschnitt (58) und der zweite Schichtabschnitt (60) über mindestens zwei diskrete Kondensatorelemente (C1, C2, C3, C4) kapazitiv gekoppelt sind,
**dadurch gekennzeichnet, dass** der erste Schichtabschnitt (58) und der zweite Schichtabschnitt (60) zumindest teilweise einander derart gegenüberliegend angeordnet sind, dass der erste Schichtabschnitt (58) und der zweite Schichtabschnitt (60) einen Kondensator (C9) bilden.

2. Elektromagnetische Filteranordnung (44) nach Anspruch 1, wobei die mindestens zwei diskreten Kondensatorelemente (C1, C2, C3, C4) gleichmäßig um einen Umfang der ersten Öffnung (48) verteilt sind.

3. Elektromagnetische Filteranordnung (44) nach einem der vorhergehenden Ansprüche, wobei der zweite Schichtabschnitt (60) ringförmig ist und wobei sich die erste Leiterschnittstelle (74) um die erste Öffnung (48) herum in einer umfangsmäßig geschlossenen Weise erstreckt.

4. Elektromagnetische Filteranordnung (44) nach einem der vorhergehenden Ansprüche, wobei die Basisplatte (46) eine zweite Öffnung (50) aufweist, die eingerichtet ist, um von einem zweiten Leiter (54) durchdrungen zu sein, von dem die elektromagnetische Störung zumindest teilweise ausgeht,
wobei die Basisplatte (46) einen elektrisch leitenden dritten Schichtabschnitt (62) umfasst, wobei der dritte Schichtabschnitt (62) eine zweite Leiterschnittstelle (76) umfasst, die eingerichtet ist, um den dritten Schichtabschnitt (62) mit dem zweiten Leiter (54) auf elektrisch leitende Weise zu verbinden,
wobei der erste Schichtabschnitt (58) und der dritte Schichtabschnitt (62) über mindestens zwei diskrete Kondensatorelemente (C5, C6, C7, C8) kapazitiv gekoppelt sind.

5. Elektromagnetische Filteranordnung (44) nach einem der Ansprüche 1 bis 3, wobei die Basisplatte (46) eine zweite Öffnung (50) aufweist, die eingerichtet ist, um einen zweiten Leiter (54) aufzunehmen, von dem die elektromagnetische Störung zumindest teilweise ausgeht,
wobei die Basisplatte (46) einen elektrisch leitenden dritten Schichtabschnitt (62) umfasst, wobei der dritte Schichtabschnitt (62) eine zweite Leiterschnittstelle (76) umfasst, die eingerichtet ist, um den dritten Schichtabschnitt (62) mit dem zweiten Leiter (54) auf elektrisch leitende Weise zu verbinden,
wobei die Basisplatte (46) einen elektrisch leitenden vierten Schichtabschnitt (80) umfasst,
wobei der vierte Schichtabschnitt (80) eine Abschirmungsschnittstelle (82) umfasst, die eingerichtet ist, um den vierten Schichtabschnitt (80) mit der Abschirmung (66) auf elektrisch leitende Weise zu verbinden,
wobei der dritte Schichtabschnitt (62) und der vierte Schichtabschnitt (80) zumindest teilweise derart gegenüberliegend angeordnet sind, dass der dritte Schichtabschnitt (62) und der vierte Schichtabschnitt (80) einen Kondensator (C11) bilden und/oder wobei der dritte Schichtabschnitt (62) und der vierte Schichtabschnitt (80) über mindestens zwei diskrete Kondensatorelemente (C5, C6, C7, C8) kapazitiv gekoppelt sind.

6. Elektromagnetische Filteranordnung (44) nach Anspruch 4 oder 5, wobei die mindestens zwei diskreten Kondensatorelemente (C5, C6, C7, C8) gleichmäßig um einen Umfang der zweiten Öffnung (50) verteilt sind.

7. Elektromagnetische Filteranordnung (44) nach einem der vorhergehenden Ansprüche, wobei die Abschirmungsschnittstelle (64, 82) mehrere Abschirmungsschnittstellenabschnitte (68) umfasst, die voneinander beabstandet sind.

8. Elektromagnetische Filteranordnung (44) nach Anspruch 7, wobei sich jeder Abschirmungsschnittstellenabschnitt (68) zumindest teilweise um ein entsprechendes Abschirmungsverbindungsloch (70) erstreckt, das eingerichtet ist, um einen Abschirmungsverbindungsbolzen (72) aufzunehmen.

9. Elektromagnetische Filteranordnung (44) nach einem der vorhergehenden Ansprüche, wobei die Abschirmungsschnittstelle (64) mindestens einen Abschirmungsschnittstellenabschnitt (68) umfasst, der sich entlang eines Randes des ersten Schichtabschnitts (58) erstreckt.

10. Durchführungsanordnung (42), umfassend eine elektromagnetische Filteranordnung (44) nach einem der vorhergehenden Ansprüche und einen ersten Leiter (52), wobei sich der erste Leiter (52) durch die erste Öffnung (48) erstreckt und über die erste Leiterschnittstelle (74) mit dem zweiten Schichtabschnitt (60) auf elektrisch leitende Weise verbunden ist.

11. Gehäuseanordnung (28) für mindestens eine elektrische Komponente, umfassend eine elektromagnetische Filteranordnung (44) nach einem der Ansprüche 1 bis 9 und ein Gehäuse (30) mit mindestens einer Wand (32),
wobei die Wand (32) eine Wandöffnung (34) aufweist, die zumindest teilweise von der Basisplatte (46) der elektromagnetischen Filteranordnung (44) bedeckt ist, und wobei der erste Schichtabschnitt (58) über die Abschirmungsschnittstelle (64) mit der Wand (32) auf elektrisch leitende Weise verbunden ist.

12. Gehäuseanordnung (28) nach Anspruch 11, ferner umfassend einen ersten Leiter (52), wobei sich der erste Leiter (52) durch die erste Öffnung (48) erstreckt und über die erste Leiterschnittstelle (74) mit dem zweiten Schichtabschnitt (60) auf elektrisch leitende Weise verbunden ist.

13. Fahrzeug (10), umfassend eine Gehäuseanordnung (28) nach Anspruch 11 oder 12, wobei die Gehäuseanordnung (28) einen Teil eines Antriebsstrangs (12) des Fahrzeugs (10) bildet.

## Revendications

1. Ensemble filtre électromagnétique (44) destiné à atténuer des interférences électromagnétiques, comprenant une plaque de base (46) comportant une première ouverture (48) configurée pour être pénétrée par un premier conducteur (52) duquel provient au moins partiellement l'interférence électromagnétique,
dans lequel la plaque de base (46) comprend une couche de support électriquement non conductrice (56), une première section de couche électriquement conductrice (58) et une deuxième section de couche électriquement conductrice (60),
dans lequel la première section de couche (58) comprend une interface de blindage (64) configurée pour connecter la première section de couche (58) à un blindage (66) de manière électriquement conductrice,
dans lequel la deuxième section de couche (60) comprend une interface de premier conducteur (74) configurée pour connecter la deuxième section de couche (60) au premier conducteur (52) de manière électriquement conductrice, et
dans lequel la première section de couche (58) et la deuxième section de couche (60) sont couplées de manière capacitive via au moins deux éléments condensateurs discrets (C1, C2, C3, C4),
**caractérisé en ce que** la première section de couche (58) et la deuxième section de couche (60) sont disposées au moins partiellement de manière opposée l'une à l'autre de telle sorte que la section de couche (58) et la deuxième section de couche (60) forment un condensateur (C9).

2. Ensemble filtre électromagnétique (44) selon la revendication 1, dans lequel lesdits au moins deux éléments condensateurs discrets (C1, C2, C3, C4) sont répartis uniformément autour d'une circonférence de la première ouverture (48).

3. Ensemble filtre électromagnétique (44) selon l'une quelconque des revendications précédentes, dans lequel la deuxième section de couche (60) est en forme d'anneau et dans lequel l'interface de premier conducteur (74) s'étend autour de la première ouverture (48) de manière circonférentiellement fermée.

4. Ensemble filtre électromagnétique (44) selon l'une quelconque des revendications précédentes, dans lequel la plaque de base (46) comporte une deuxième ouverture (50) configurée pour être pénétrée par un deuxième conducteur (54) duquel provient au moins partiellement l'interférence électromagnétique,
dans lequel la plaque de base (46) comprend une troisième section de couche électriquement conductrice (62), dans lequel la troisième section de couche (62) comprend une interface de deuxième conducteur (76) configurée pour connecter la troisième section de couche (62) au deuxième conducteur (54) de manière électriquement conductrice,
dans lequel la première section de couche (58) et la troisième section de couche (62) sont couplées de manière capacitive via au moins deux éléments condensateurs discrets (C5, C6, C7, C8).

5. Ensemble filtre électromagnétique (44) selon l'une quelconque des revendications 1 à 3, dans lequel la plaque de base (46) comporte une deuxième ouverture (50) configurée pour recevoir un deuxième conducteur (54) duquel provient au moins partiellement l'interférence électromagnétique,
dans lequel la plaque de base (46) comprend une troisième section de couche électriquement conductrice (62),
dans lequel la troisième section de couche (62) comprend une interface de deuxième conducteur (76) configurée pour connecter la troisième section de couche (62) au deuxième conducteur (54) de manière électriquement conductrice,
dans lequel la plaque de base (46) comprend une quatrième section de couche électriquement conductrice (80),
dans lequel la quatrième section de couche (80) comprend une interface de blindage (82) configurée pour connecter la quatrième section de couche (80) au blindage (66) de manière électriquement conductrice,
dans lequel la troisième section de couche (62) et la quatrième section de couche (80) sont disposées au moins partiellement de manière opposée l'une à l'autre de telle sorte que la troisième section de couche (62) et la quatrième section de couche (80) forment un condensateur (C11) et/ou dans lequel la troisième section de couche (62) et la quatrième section de couche (80) sont couplées de manière capacitive via au moins deux éléments condensateurs discrets (C5, C6, C7, C8).

6. Ensemble filtre électromagnétique (44) selon la revendication 4 ou 5, dans lequel lesdits au moins deux éléments condensateurs discrets (C5, C6, C7, C8) sont répartis uniformément autour d'une circonférence de la deuxième ouverture (50).

7. Ensemble filtre électromagnétique (44) selon l'une quelconque des revendications précédentes, dans lequel l'interface de blindage (64, 82) comprend une pluralité de sections d'interface de blindage (68) espacées les unes des autres.

8. Ensemble filtre électromagnétique (44) selon la revendication 7, dans lequel chaque section d'interface de blindage (68) s'étend au moins partiellement autour d'un trou de connexion de blindage respectif (70) configuré pour recevoir un boulon de connexion de blindage (72).

9. Ensemble filtre électromagnétique (44) selon l'une quelconque des revendications précédentes, dans lequel l'interface de blindage (64) comprend au moins une section d'interface de blindage (68) s'étendant le long d'un bord de la première section de couche (58).

10. Ensemble traversée (42), comprenant un ensemble filtre électromagnétique (44) selon l'une quelconque des revendications précédentes et un premier conducteur (52), dans lequel le premier conducteur (52) s'étend à travers la première ouverture (48) et est connecté à la section de deuxième couche (60) de manière électriquement conductrice via l'interface de premier conducteur (74).

11. Ensemble enceinte (28) pour au moins un composant électrique, comprenant un ensemble filtre électromagnétique (44) selon l'une quelconque des revendications 1 à 9 et un boîtier (30) comportant au moins une paroi (32),
dans lequel la paroi (32) comporte une ouverture (34) qui est au moins partiellement recouverte par la plaque de base (46) de l'ensemble filtre électromagnétique (44), et dans lequel la première section de couche (58) est connectée à la paroi (32) de manière électriquement conductrice via l'interface de blindage (64).

12. Ensemble enceinte (28) selon la revendication 11, comprenant en outre un premier conducteur (52), dans lequel le premier conducteur (52) s'étend à travers la première ouverture (48) et est connecté à la deuxième section de couche (60) de manière électriquement conductrice via l'interface de premier conducteur (74).

13. Véhicule (10) comprenant un ensemble enceinte (28) selon la revendication 11 ou 12, dans lequel l'ensemble enceinte (28) fait partie d'un groupe motopropulseur (12) du véhicule (10).
